# EUROPÄISCHE PATENTSCHRIFT

(11) **EP 1 133 053 B1**
(45) Veröffentlichungstag und Bekanntmachung des Hinweises auf die Patenterteilung: **25.11.2009**
(21) Anmeldenummer: 01890064.7
(22) Anmeldetag: 07.03.2001
(51) Int. Cl.: H03H 9/05

(54) **Piezoelektrische Resonatoranordnung**
Piezoelectric resonator device
Dispositif résonateur piézoélectrique

(30) Priorität: 08.03.2000 AT 3852000
(43) Veröffentlichungstag der Anmeldung: 12.09.2001
(73) Patentinhaber: AVL List GmbH, 8020 Graz (AT)
(72) Erfinder: Thanner, Herbert J., 8051 Graz (AT)
(74) Vertreter: Laminger, Norbert

(56) Entgegenhaltungen:
- EP-A- 0 070 503
- GB-A- 2 146 839
- US-A- 4 642 511
- US-A- 5 250 871

## Beschreibung

Die Erfindung betrifft eine piezoelektrische Resonatoranordnung, umfassend eine Halterung mit zumindest zwei Halterungselementen und zumindest einem plättchenförmigen piezoelektrischen Resonator mit mindestens einer Anregungselektrode, von der zumindest ein elektrisch leitender Streifen vorzugsweise radial in Richtung des Randes des Resonators hin ausgeht, wobei der Resonator zwischen den Halterungselementen eingespannt ist, von welchen zumindest eines auf den Resonator hin mit einer Kraft beaufschlagt ist, und die unmittelbar und direkt an der bzw. einer der Mantelflächen des Resonators anliegen.

Die Resonanzfrequenz eines piezoelektrischen Resonators ist neben den effektiv wirkenden Materialkonstanten und den physikalischen Abmessungen maßgeblich von der Wechselwirkung mit seiner Umgebung (z.B.: Druck, Temperatur, Massenbeladung) abhängig. Daraus ergeben sich in natürlicher Weise zwei grundsätzlich unterschiedliche Anwendungsbereiche. Zum Einen werden piezoelektrische Resonatoren als Frequenznormal verwendet, wobei sich der Resonator üblicherweise im Rückkopplungszweig eines Oszillators befindet und dadurch die Oszillatorfrequenz in der Nähe Resonanzfrequenz stabilisiert. Bei dieser Anwendung werden die Einflüsse der Umgebung auf die Resonanzfrequenz durch hermetisch dichte Gehäuse, welche entweder mit Schutzgas gefüllt oder evakuiert sind möglichst konstant gehalten. Zum Anderen werden piezoelektrische Resonatoren als Sensorelement verwendet, wobei aus den gemessenen Änderungen der Resonanzeigenschaften auf die physikalischen bzw. chemischen Eigenschaften bzw. deren zeitliche Änderung der Umgebung Rückschlüsse gezogen werden. In beiden Anwendungsbereichen ist eine Halterung und Kontaktierung des Resonators erforderlich.

Im Falle der Frequenznormale wird der Resonator üblicherweise in genormten Gehäusen montiert, wobei die Elektroden mit den Zuleitungen elektrisch leitend verklebt sind und daher der Resonator nicht austauschbar ist. Im Falle der Mikrowaagen-Sensoranwendung (engl. QCM- Quartz Crystal Microbalance) wird der Resonator (Dickenscherschwinger) in entsprechend konstruierten Halterungen welche üblicherweise zerlegbar sind eingebaut. Der Resonator wird dabei durch federnde Kontaktelemente, welche auf den Resonator axial wirkende Haltekräfte ausüben und somit diesen auch gegen den auf Massepotential liegenden Halterungsteil drückt, beidseitig kontaktiert und stabil in Position gehalten (z.B.: Mikrowaagen Sensorhalter der Fa. Leybold Inficon).

Durch Variation der Temperatur kommt es bei dieser ,axialen` Kontaktierung bzw. Halterung neben unterschiedlichen thermischen Ausdehnungen zwischen der Resonatoroberfläche und der Halterung auch zu Änderungen der Kontaktkräfte der Federelemente und somit zu undefinierten Übergangswiderständen. Um thermisch verursachten Einflüsse auf die Resonanzfrequenz möglichst zu minimieren, werden daher sowohl temperaturkompensierte Schnitte verwendet (z. B. Quarz AT-Schnitt), als auch die Halterung während der Messung gekühlt bzw. thermostatisiert.

Eine axiale Kontaktierung ist auch bei der Halterung des piezoelektrischen Resonators gemäß der DE 34 27 646 A vorhanden, bei der der Resonator mit einer seiner ebenen Deckflächen auf Fahnen der Resonatorhalter aufliegt und durch Verklebung darauf fixiert ist. Auch hier kommt es also zu den unerwünschten Beeinflussungen der Schwingungseigenschaften des Kristalls durch axiale Kontaktierung und Halterung. Ähnlich sowohl in Konstruktion als auch negativen Auswirkungen auf die Schwingungseigenschaften des Resonators ist die Halterung gemäß der JP 57-92913 A. Auch hier wird ein scheibenförmiges Resonatorplättchen durch axiale Auflage und Verklebung mit den Halterungselementen positioniert und fixiert, auf welchen Halterungselementen weiters auch noch Positionierhilfen in Form von an den Mantelflächen des Resonators anliegenden Elementen vorhanden sind.

Schließlich sei auch noch die in der genannten japanischen Offenlegungsschrift zum Stand der Technik angeführte und dargestellte Konstruktion genannt, bei welcher zwei Haltefahnen mit parallelen Längsschlitzen zum Einsetzen des Resonatorplättchens vorhanden sind. Die unter, allenfalls auch die obere Deckfläche des Resonatorplättchens liegen auf der Kante des Längsschlitzes mit einem Teil ihrer Oberfläche auf, so dass auch hier eine negative Beeinflussung der Schwingungseigenschaften möglich ist, insbesonders bei der typischerweise ebenfalls vorgesehenen Verklebung des Resonatorplättchens mit dem Haltefahnen.

Für Flächenscherschwinger ist in der EP 0 626 212 B1 eine Haltestruktur beschrieben, bei welcher die Halterungselemente an den Deckflächen eines flachen Resonators anliegen und diesen durch elastische, axial wirkende Druckkräfte einspannen sowie die auf den Deckflächen angeordneten Elektroden elektrisch kontaktieren. Für Dickenscher- oder auch Dickendehnschwinger ist diese Anordnung aufgrund der völlig anders liegenden Schwingungsknotenebenen in keinem Fall anwendbar. Auch führt diese Art der Halterung bei denjenigen Anwendungen zu Schwierigkeiten oder Behinderungen, bei welchen die freie Zugänglichkeit der Elektroden oder anderer Strukturen auf der oder den Deckfläche(n) des Resonators wesentlich ist, beispielsweise bei Mikrowaagen, bei welchen auf den Deckflächen Partikel abgeschieden werden sollen und dazu oftmals auch Beschichtungen aufgebracht sind, die der Abscheidung der zu bestimmenden Partikel dienen.

Aufgabe der Erfindung ist es, eine einfache Anordnung zur mechanischen Halterung einschließlich der elektrischen Kontaktierung eines piezoelektrischen Resonators vorzuschlagen, bei welcher für Resonatoren aller Anwendungsgebiete, insbesonders für Mikrowaagen- und/oder Sensor-Anwendungen, die Schwingungs- und Resonanzeigenschaften möglichst unbeeinflusst von der Halterung und Kontaktierung bleiben. Dieser Vorteil soll darüber hinaus in einem großen Temperaturbereich gegeben sein, um damit auch die temperaturbedingte Hysterese der Resonanzeigenschaften zu minimieren.

Diese Aufgabe wird gemäß der vorliegenden Erfindung dadurch gelöst, dass der Resonator verklebungsfrei zwischen den Halterungselementen fixiert ist, sich der elektrisch leitende Streifen zumindest bis auf die Mantelfläche des Resonators erstreckt, und mindestens eine verklebungsfreie elektrische Kontaktstelle mit dem Resonator an der bzw. einer der Mantelflächen des Resonators vorgesehen ist, wobei die elektrischen Kontaktierungskräfte im wesentlichen mit dem Resonator in einer Ebene liegen. Damit ist das Einsetzen des Resonators wesentlich vereinfacht, da keine zusätzlichen Verklebungen vorgesehen werden müssen, die zwischen den Halterungselementen und dem Resonatormaterial eine Zwischenschicht bilden. Die Halte- und auch Kontaktierungskräfte sind bereits allein durch die Halterungselemente an sich gegeben. Dies ermöglicht auch den einfachen Einbau und zerstörungsfreien Austausch des Resonators, wobei vorteilhafterweise beim Einsetzen auch gleich alle notwendigen elektrischen Verbindungen ohne weiteren Aufwand hergestellt werden. Natürlich könnte aber die Beaufschlagung des Resonators mit dem die Schwingungen anregenden elektrischen Feld zusätzlich auch berührungsfrei oder durch Kontaktstellen erfolgen, welche unabhängig zu den Halterungselementen vorgesehen sind.

Darüber hinaus werden auch Diffusionseffekte zwischen Kleber und Elektroden verhindert, die bei Einsatz bei hohen Temperaturen auftreten und Einfluss auf die Resonanzfrequenzen haben. Dadurch wirken aber auch die Halte- und allenfalls auch Kontaktierungskräfte, zumindest die Resultierende aller dieser Kräfte, radial auf den Resonator ein und jegliche axiale Kraftkomponente auf die Deckflächen des Resonatorplättchens und damit auch jegliche negative Beeinflussung der Schwingungseigenschaften des Resonators können vermieden werden. Sowohl für Dickenscher- als auch Dickendehnschwinger ergibt sich damit eine Anordnung, in der die Halte- und allfälligen Kontaktierungskräfte parallel zur Knotenebene der piezoelektrisch anregbaren Hauptschwingung wirken, wodurch auch diese Kräfte die Schwingungseigenschaften nur im geringsten möglichen Ausmaß beeinflussen. Für alle Arten von Resonatoren sind, bei guter mechanischer Halterung und einfacher elektrischer Kontaktierung die Deckflächen ungehindert zugänglich, so dass beispielsweise die Abscheidung von Partikeln auf dem Resonator im Falle von Mikrowaagen-Anwendungen in keiner Weise behindert wird.

Gemäß einer weiteren vorteilhaften Ausführungsform der Erfindung sind die von den Halterungselementen ausgeübten elektrischen Kontaktierungskräfte im wesentlichen radial zum Zentrum des Resonators hin gerichtet.

Um in einfacher Weise die mechanischen Halterungskräfte und auch die elektrischen Kontaktierungskräfte mit möglichst geringem Aufwand und einer einfachen Konstruktion verwirklichen zu können, ist gemäß einem weiteren Merkmal der Erfindung an zumindest einem der Halterungselemente zumindest eine elektrische Kontaktfläche vorgesehen und zumindest einer der Mantelflächen des Resonators zugewandt.

Bei einer vorteilhaften Ausführungsform der erfindungsgemäßen Anordnung ist vorgesehen, daß an zumindest zwei Halterungselementen zumindest je eine elektrische Kontaktfläche vorgesehen und zumindest einer der Mantelflächen des Resonators zugewandt ist, dass von mindestens einer Anregungselektrode des Resonators mindestens ein zweiter elektrisch leitfähiger Streifen vorzugsweise radial ausgeht und beide leitfähigen Streifen sich bis auf die Mantelfläche des Resonators und in den Bereich jeweils einer der elektrischen Kontaktflächen der Halterungselemente erstrecken. Über diese elektrisch leitende Verbindung der Kontaktflächen an den Halterungselementen über die Anregungselektrode am Resonator können elektrischen Größen unmittelbar bestimmt oder vorgegeben werden, aber auch andere, mit diesen elektrischen Größen zusammenhängende Parameter.

So kann beispielsweise der elektrische Widerstand zwischen den Kontaktstellen am Resonator bestimmt werden, wenn die elektrischen Kontaktflächen von zwei Halterungselementen über zumindest eine Anordnung zur Messung des elektrischen Widerstandes miteinander verbunden sind. Der Widerstand kann dann als Maß für die jeweilige Temperatur der betreffenden Anregungselektrode bzw. des Resonators herangezogen werden.

Umgekehrt ist es aber auch möglich, über eine entsprechend ausgelegte Schaltung den Resonator durch direkten Stromfluß durch mindestens eine Elektrode zu heizen bzw. thermostatisieren, wenn gemäß einer anderen Variante die elektrischen Kontaktflächen von zwei Halterungselementen über zumindest eine Anordnung zur Erzeugung und Regelung eines Stromflusses miteinander verbunden sind.

Um die Halte- und allenfalls auch Kontaktierungskräfte über den gesamten Anwendungstemperaturbereich konstant zu halten und auch Fertigungstoleranzen in der Abmessung des Resonators ausgleichen zu können, ist gemäß einem weiteren Merkmal der Erfindung zumindest eines der Halterungselemente elastisch gelagert bzw. mit der Basisstruktur elastisch federnd verbunden.

Bei einer vorteilhaften Ausführungsform der Erfindung ist vorgesehen, dass zumindest eines der Halterungselemente aus einem im wesentlichen starren und einem im wesentlichen elastisch verformbaren Teil besteht, wobei der elastische Teil näher der Basisstruktur liegt. In einer derartigen Anordnung sind jene Teile der Halterungsanordnung, die für den Betrag der Halterungskräfte verantwortlich sind, außerhalb des Bereiches angeordnet, in welchem sich Temperaturänderungen bevorzugt ereignen. Die Halte- und Kontaktierungskräfte können auch hier über den gesamten Anwendungstemperaturbereich im wesentlichen konstant gehalten und die Toleranzen ausgeglichen werden. Beispielsweise ist bei Sensoranordnungen mit sich während des Betriebs ergebender Erwärmung des Volumens um den Resonator oder des Resonators selbst der elastische Teil davon entfernt, so dass sich die Erwärmung nur zu einem geringen Teil oder überhaupt nicht auf die mechanischen und elastischen Eigenschaften des elastisch verformbaren Teils der Halterungsanordnung auswirken kann. Daher ist der Temperaturgang der Resonanzfrequenz eines piezoelektrischen Resonators in der erfindungsgemäßen Halterungsanordnung nur geringgradig beeinflusst von der Halterung und auch die Hysterese der Resonanzfrequenz ist in einem Temperaturbereich von Raumtemperatur bis ca. 700°C verringert.

Gemäß einer vorteilhaften Ausführungsform der Erfindung ist zumindest eines der Halterungselemente als länglicher Haltearm mit zumindest einem im wesentlichen starren Längsabschnitt und einem im wesentlichen elastisch verformbaren Abschnitt ausgeführt, womit eine gute Haltewirkung und Formbeständigkeit, insbesonders bei Anordnung des starren Abschnittes beim Resonator, erreicht ist und der Resonator einfach eingesetzt und ausgetauscht werden kann, da zumindest ein wesentlicher Abschnitt des Haltearmes für diesen Zweck zur Seite bewegt werden kann.

Eine stabilere Anordnung ist dagegen zu erzielen, wenn zumindest ein im wesentlichen starres Halterungselement elastisch federnd am Ende eines im wesentlichen starren, länglichen Haltearmes gelagert ist.

Wenn vorgesehen ist, dass die Halterungselemente mit Haltestrukturen versehen sind, die eine definierte Orientierung des eingesetzten Resonators vorgeben, kann die vorteilhafte Ausrichtung des Resonators in bezug auf die Halterungselemente und die von ihnen ausgeübten Kräfte sicher gewährleistet werden und die Handhabung, insbesonders das Einsetzen des Resonators in die Anordnung wird wesentlich vereinfacht.

Vorteilhafterweise ist in allen der bisher genannten Ausführungsformen vorgesehen, dass zumindest die Halterungselemente, vorzugsweise auch die Basisstruktur, vorzugsweise einstückig aus einem Keramikmaterial angefertigt sind. Diese Materialwahl vereint einfache Herstellung mit besten mechanischen und wärmetechnischen Eigenschaften.

Um eine für die meisten Anwendungstemperaturbereiche beständige Halterungsanordnung zu erlangen, bestehen die notwendigen elektrische Leitungen und Kontaktflächen auf der Halterungsanordnung aus direkten Beschichtungen aus leitfähigen Materialien. Vorzugsweise sind dabei aufgesputterten Metallbeschichtungen vorgesehen. Damit ist die Temperaturbeständigkeit der Leitungsstrukturen bis zu ca. 800°C gegeben.

Eine besonders vorteilhafte Kombination der radialen mechanischen Halterung und elektrischen Kontaktierung mit optimaler Zugänglichkeit der Deckflächen flacher Resonatorplättchen mit den Schwingungseigenschaften des Resonators selbst ist gegeben, wenn gemäß einem weiteren Merkmal der Erfindung der Resonator ein Dickenscher- oder Dickendehnschwinger ist. Aufgrund der Lage der Knotenebenen dieser speziellen Resonatoren ist mit der Kraftausübung zur Halterung und Kontaktierung in der Ebene des Resonatorplättchens, vorzugsweise sogar der radialen Kraftausrichtung, die geringstmögliche Beeinflussung der Schwingungsparameter durch die dazu notwendigen Kräfte gewährleistet.

Vorteilhafterweise ist der Resonator mit zumindest einer Beschichtung, insbesonders einer die Abscheidung von Partikeln auf der Resonatoroberfläche erlaubenden bzw. verbessernden Beschichtung, versehen.

In der nachfolgenden Beschreibung soll die Erfindung anhand von in den Zeichnungen dargestellten Ausführungsbeispielen näher erläutert werden.

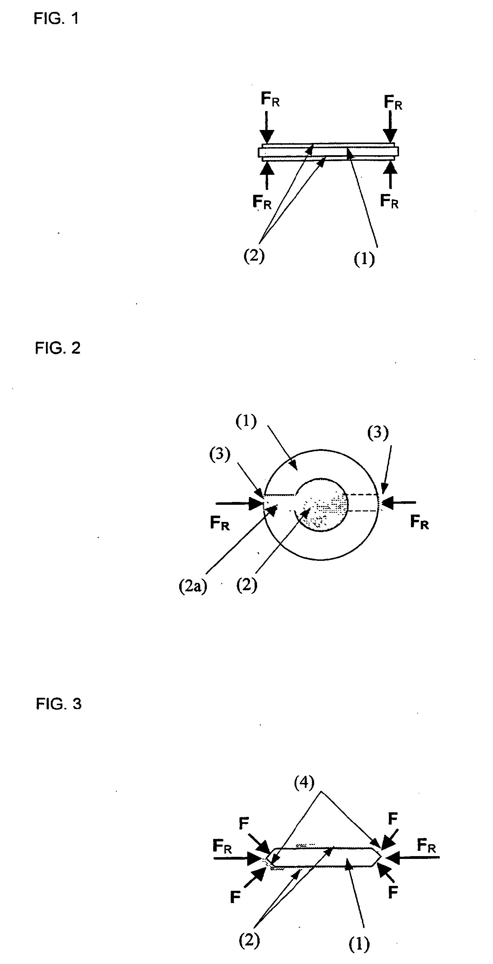

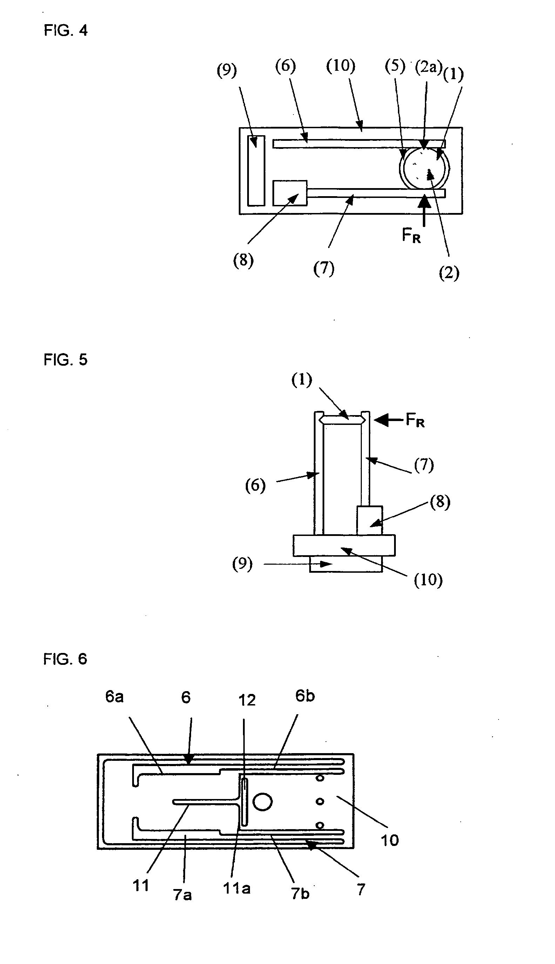

Dabei zeigt die Fig. 1 die Kräfte auf ein Resonatorplättchen gemäß dem Stand der Technik, Fig. 2 ist eine Draufsicht auf ein erfindungsgemäßes kreisrundes Resonatorplättchen mit Elektroden und sich bis zu dessen Rand erstreckendem leitendem Abschnitt, Fig. 3 ist eine Seitenansicht gemäß Fig. 1 auf das Plättchen der Fig. 2 mit im wesentlichen radialer Halterung, Fig. 4 ist eine Anordnung mit Haltearmen, welche parallel zum Resonatorplättchen ausgerichtet sind, Fig. 5 ist eine Anordnung mit senkrecht auf das Resonatorplättchen stehenden Haltearmen und Fig. 6 zeigt eine Draufsicht auf ein ebenes Keramikplättchen als Halterungsanordnung.

Obwohl andere Formgebungen möglich sind, ist die bevorzugte Form für piezoelektrische Resonatoren, insbesonders für Mikrowaagen-Sensoranwendungen und als Frequenznormale, die in den Zeichnungsfiguren dargestellte flache, im wesentlichen scheibenförmige Ausbildung. Dabei sind, wie dies in Fig. 1 besonders deutlich erkennbar ist, auf dem kreisrunden Resonatorplättchen 1 Elektroden 2 aufgebracht. Diese Elektroden 2 können, bei Mikrowaagen-Anordnungen als Auffang- und Gegenelektrode vorgesehen sein. Selbstverständlich könnte auch nur eine Elektrode auf einer Seite des Resonatorplättchens 1 vorhanden sein. Auch zusätzliche Beschichtungen zur Verbesserung der Abscheidung von Partikeln auf dem Resonatorplättchen 1 sind möglich, auf den oder die Elektroden 2 umgebend. Die oder zumindest eine Elektrode 2 ist bis nahe an den Rand des Resonators 1 aufgebracht. Bei einer solchen Anordnung wie in Fig. 1 wirken die Halte- bzw. Kontaktkräfte FR gemäß dem Stand der Technik am Rand der Resonators in axialer Richtung also normal auf die Knotenebene der piezoelektrisch anregbaren Hauptschwingung (Dickenscher- bzw. Dickendehnschwingung).

Demgegenüber ist gemäß der vorliegenden Erfindung vorgesehen, dass, wie in Fig. 2 dargestellt ist, das Resonatorplättchen 1 an seinem Rand durch Halterungselemente getragen wird, die an zumindest zwei Einspannstellen 3 auf das Resonatorplättchen radial einwirkende Kräfte FR hervorrufen. In diesem Fall liegen die Kraftvektoren FR in der Knotenebene der piezoelektrisch anregbaren Hauptschwingung (Dickenscher- bzw. Dickendehnschwingung). Bei dem Resonator 1 sind dann vorzugsweise die Elektroden 2, welche nur einen Teil der flachen Oberfläche(n) des Plättchens 1 bedecken, mit leitenden Streifen, sogenannten Kontaktfahnen 2a, versehen. Diese erstrecken sich vorzugsweise radial orientiert bis auf die Mantelfläche des Resonatorplättchens 1. Bei dieser Ausbildung der Elektroden wird der Resonator 1 an seinem Rand durch radial wirkende Kräfte FR gehalten und auch der elektrische Kontakt wird gleichzeitig durch Kontaktflächen an den Halterungselementen hergestellt, die mit den Enden der radialen Kontaktfahnen 2a auf der Mantelfläche in Berührung kommen. Alternativ dazu wäre auch eine von der Halterung getrennte elektrische Kontaktierung durch separate Kontaktelemente, jedoch auch in der Ebene des Resonatorplättchens 1 und über die Mantelfläche erfolgend, möglich. Die Kraftvektoren der Haltekräfte liegen bei der erfindungsgemäßen Anordnung vorzugsweise in der Knotenebene der piezoelektrisch anregbaren Hauptschwingung des Resonators, der eine entsprechende kristallographische Orientierung aufweist. Dies gilt sowohl für Dickenscher- als auch für Dickendehnschwingungen.

In Fig. 3 ist ein Resonator 1 mit beidseitiger Phase am Rand und ähnlicher Elektrodengeometrie wie in Abbildung 2 dargestellt, jedoch reichen die Kontaktfahnen 2a bis an die Knotenebene der piezoelektrisch anzuregenden Hauptschwingung (Dickenscher- bzw. Dickendehnschwingung). In dieser Ausführung treten an der Phase die Halte- und Kontaktierungskräfte (F) auf, wobei die resultierenden Halte- bzw. Kontaktkräfte (FR) wieder parallel zur Knotenebene der piezoelektrisch anzuregenden Hauptschwingung liegen, also radial auf das Resonatorplättchen 1 wirken. Der Umfangsbereich des Resonatorplättchens 1 ist nicht flach, sondern in eine Kante zulaufend gestaltet, so dass im Zusammenwirken mit entsprechenden Strukturen in den Halterungselementen eine genau definierte Ausrichtung des Resonators 1 vorgegeben und sicher einhaltbar ist. Auch beim Einsetzen und Austauschen des Resonatorplättchens 1 erleichtert eine derartige Ausführung die Handhabung und macht langwierige Justierungen überflüssig.

Fig. 4 zeigt eine mögliche Anordnung, in welcher das Resonatorplättchen 1 in der durch zwei gegenüberliegenden länglichen Haltearme 6, 7 definierten Ebene liegt. Der Haltearm 6 ist dabei im wesentlichen starr ausgeführt und vorzugsweise auch fest mit der Grundplatte 10 der Basisstruktur der Halterungsanordnung verbunden, während der ebenfalls im wesentlichen starre Haltearm 7 über ein elastisches Element 8 oder einen elastisch verformbaren Längsabschnitt mit der Basisstruktur verbunden ist und derart die weitestgehend temperaturunabhängigen Halte- bzw. Kontaktierungskräfte FR auf das Resonatorplättchen 1 ausübt. Der elektrische Kontakt wird über den Anschluss 9 und den Haltearmen 6, 7 auf die Elektroden 2 des Resonators hergestellt.

Fig. 5 zeigt ein weiteres Beispiel einer möglichen Anordnung in welcher das Resonatorplättchen 1 normal auf die durch die beiden Haltearme 6, 7 definierten Ebene steht. Auch in dieser Anordnung werden die Halte- bzw. Kontaktierungskräfte FR durch den Haltearm 7, welcher über das elastische Element 8 mit der Grundplatte 10 verbunden ist, erzeugt und der elektrische Kontakt über den Anschluss 9 und den Haltearmen 6, 7 auf die Elektroden des Resonatorplättchens 1 hergestellt. Der Haltearm 6 ist mit der Grundplatte 10 fest verbunden.

Eine weitere Ausführungsform einer erfindungsgemäßen Halterungsanordnung zeigt die Fig. 6, in welche eine Draufsicht auf eine Keramik-Halterungsanordnung dargestellt ist. Dabei sind zwei längliche Halterungsarme 6 und 7 aus einem flachen Keramikplättchen ausgeschnitten und daher vorteilhafterweise einstückig mit der Basisstruktur 10 hergestellt, welche Basisstruktur durch den in der Zeichnung rechten Abschnitt des Keramikplättchens gebildet ist. Die Haltearme 6, 7 bestehen aus zwei Längsabschnitten, von welchen derjenige Längsabschnitt 6a, 7a, der mit dem Resonatorplättchen 1 in Kontakt kommt und auch im Bereich der größten Erwärmung liegt, mit größerem Querschnitt und daher im wesentlichen starr ausgeführt ist. Die Erwärmung kann auch erwünscht und dabei besonders intensiv sein, insbesonders bei Sensor- und Mikrowaagen-Anordnungen. Die der Basisstruktur 10 näher liegenden Längsabschnitte 6b, 7b sind mit geringerem Querschnitt ausgeführt, sind daher elastisch verformbar und für die Ausübung der Halte- und allenfalls auch Kontaktierungskräfte zur Elektrode 2 auf dem Resonatorplättchen 1 verantwortlich. Da sie außerhalb des Bereichs der Erwärmung des Resonatorplättchens 1 liegen und überdies die eingebrachte Wärme rasch auf die Basisstruktur 10 übertragen können, werden deren mechanische und elastische Eigenschaften von den Temperaturänderungen im Bereich des Resonatorplättchens 1 kaum bis gar nicht beeinflusst.

In Fig. 6 ist eine vorteilhafte Dreipunkt-Lagerung des Resonatorplättchens 1 dargestellt, wobei zu den Halterungsarmen 6, 7 noch ein dritter, ebenfalls mit der Basisstruktur 10 einstückig ausgeführter Halterungsarm 11 hinzutritt, der ebenfalls an der Basisstruktur 10 elastisch befestigt ist. Dazu ist an der Basis des Halterungsarms 11 ein quer zu seiner Längsachse ausgerichtetes Langloch 12 vorgesehen, welches eine elastische axiale Verschiebung des dritten Halterungsarmes 11 gestattet.

Da in allen Ausführungsformen der Erfindung zumindest zwei Halterungsarme 6, 7, 11 vorgesehen sind, können auch Resonatorplättchen 1 verwendet werden, von deren Elektrode 2 zumindest zwei im wesentlichen radiale Kontaktfahnen 2a zur Mantelfläche des Resonators 1 verlaufen. Damit ist es dann möglich, wenn an zumindest zwei Halterungselementen 6, 7, 11 zumindest je eine elektrische Kontaktfläche vorgesehen ist, über diese elektrisch leitende Verbindung elektrischen Größen der Elektrode 2, aber auch andere, mit diesen elektrischen Größen zusammenhängende Parameter des Resonators 1 selbst, unmittelbar zu bestimmen oder vorzugeben. So kann beispielsweise der elektrische Widerstand zwischen den Kontaktstellen am Resonator bestimmt werden, wenn die elektrischen Kontaktflächen von zwei Halterungselementen über zumindest eine Anordnung zur Messung des elektrischen Widerstandes miteinander verbunden sind, und als Maß für die jeweilige Temperatur der betreffenden Anregungselektrode bzw. des Resonators herangezogen werden. Umgekehrt ist es aber auch möglich, über eine entsprechend ausgelegte Schaltung den Resonator durch direkten Stromfluß durch mindestens eine Elektrode zu heizen bzw. thermostatisieren.

Die optimale Orientierung und Positionierung der elektrisch leitenden Kontaktfahnen 2a können mit Hilfe des Ratajski-Koeffizienten berechnet werden. Diese Methode erlaubt es, die Kontaktfahnen 2a derart zu legen, dass der Einfluß der Kontaktierungskräfte auf die Schwingungseigenschaften des Resonators 1, vorzugsweise die Resonanzeigenschaften, minimiert wird, indem die mechanischen Spannungen im Resonator aufgrund des Angreifens der Halterungsarme soweit als möglich reduziert werden (M. Mizan & A. Ballato, "The Stress Coefficient of Frequency of Quartz Plate Resonators", Proc. 37th AFCS, p 194-199, 1983).

Die notwendigen elektrischen Leitungen sind, wie auf allen Halterungsanordnungen möglich, durch vorzugsweise aufgesputterte Beschichtungen aus leitfähigem Metall, vorzugsweise Platin oder Gold, hergestellt.

## Patentansprüche

1. Piezoelektrische Resonatoranordnung, umfassend eine Halterung mit zumindest zwei Halterungselementen und zumindest einem plättchenförmigen piezoelektrischen Resonator mit mindestens einer Anregungselektrode, von der zumindest ein elektrisch leitender Streifen vorzugsweise radial in Richtung des Randes des Resonators hin ausgeht, wobei der Resonator zwischen den Halterungselementen eingespannt ist, von welchen zumindest eines auf den Resonator hin mit einer Kraft beaufschlagt ist, und die unmittelbar und direkt an der bzw. einer der Mantelflächen des Resonators anliegen, **dadurch gekennzeichnet, daß** der Resonator (1) verklebungsfrei zwischen den Halterungselementen (6, 7, 11) fixiert ist, sich der elektrisch leitende Streifen zumindest bis auf die Mantelfläche des Resonators erstreckt, und mindestens eine verklebungsfreie elektrische Kontaktstelle mit dem Resonator (1) an der bzw. einer der Mantelflächen des Resonators (1) vorgesehen ist, wobei die elektrischen Kontaktierungskräfte zur Herstellung des elektrischen Kontakts an besagter Kontaktstelle im wesentlichen mit dem Resonator (1) in einer Ebene liegen.

2. Anordnung nach Anspruch 1, **dadurch gekennzeichnet, dass** die von den Halterungselementen (6, 7, 11) ausgeübten elektrischen Kontaktierungskräfte im wesentlichen radial zum Zentrum des Resonators (1) gerichtet sind.

3. Anordnung nach Anspruch 1 oder 2, **dadurch gekennzeichnet, daß** an zumindest einem der Halterungselemente (6, 7, 11) zumindest eine elektrische Kontaktfläche vorgesehen und zumindest einer der Mantelflächen des Resonators (1) zugewandt ist.

4. Anordnung nach Anspruch 3, **dadurch gekennzeichnet, daß** an zumindest zwei Halterungselementen (6, 7, 11) zumindest je eine elektrische Kontaktfläche vorgesehen und zumindest einer der Mantelflächen des Resonators (1) zugewandt ist, dass von mindestens einer Anregungselektrode (2) des Resonators (1) mindestens ein zweiter elektrisch leitfähiger Streifen vorzugsweise radial ausgeht und beide leitfähigen Streifen (2a) sich bis auf die Mantelfläche des Resonators (1) und in den Bereich jeweils einer der elektrischen Kontaktflächen der Halterungselemente (6, 7, 11) erstrecken.

5. Anordnung nach Anspruch 4, **dadurch gekennzeichnet, daß** die elektrischen Kontaktflächen von zwei Halterungselementen (6, 7,11) über zumindest eine Anordnung zur Messung des elektrischen Widerstandes miteinander verbunden sind.

6. Anordnung nach Anspruch 4, **dadurch gekennzeichnet, daß** die elektrischen Kontaktflächen von zwei Halterungselementen (6, 7, 11) über zumindest eine Anordnung zur Erzeugung und Regelung eines Stromflusses miteinander verbunden sind.

7. Anordnung nach einem der Ansprüche 1 bis 6, **dadurch gekennzeichnet, dass** zumindest eines der Halterungselemente (6, 7, 11) elastisch federnd gelagert bzw. mit der Basisstruktur (10) elastisch federnd verbunden ist.

8. Anordnung nach einem der Ansprüche 1 bis 7, **dadurch gekennzeichnet, dass** die Halterungselemente (6, 7, 11) aus einem im wesentlichen starren (6, 6a, 7, 7a,11) und einem im wesentlichen elastisch verformbaren Teil (6b, 7b, 11 a, 8) besteht, wobei der elastische Teil näher der Basisstruktur (10) liegt.

9. Anordnung nach Anspruch 8, **dadurch gekennzeichnet, dass** zumindest eines der Halterungselemente als länglicher Haltearm (6, 7, 11) mit zumindest einem im wesentlichen starren Längsabschnitt (6a, 7a, 11) und einem im wesentlichen elastisch verformbaren Abschnitt (6b, 7b, 11a) ausgeführt ist.

10. Anordnung nach einem der Ansprüche 8 oder 9, **dadurch gekennzeichnet, dass** zumindest ein im wesentlichen starres Halterungselement (6, 7, 11) durch ein elastisches Element (8) federnd gelagert ist.

11. Anordnung nach einem der vorhergehenden Ansprüche, **dadurch gekennzeichnet, dass** die Halterungselemente (6, 7, 11) mit Haltestrukturen versehen sind, die eine definierte Orientierung des eingesetzten Resonators (1) vorgeben und an welchen die elektrischen Kontaktflächen vorgesehen sind.

12. Anordnung nach einem der vorhergehenden Ansprüche, **dadurch gekennzeichnet, dass** zumindest die Halterungselemente (6, 7, 11), vorzugsweise auch die Basisstruktur (10), vorzugsweise einstückig aus Keramikmaterial angefertigt ist.

13. Anordnung nach einem der vorhergehenden Ansprüche, **dadurch gekennzeichnet, dass** elektrische Leitungen und Kontaktflächen auf der Halterungsanordnung aus direkten Beschichtungen aus elektrisch leitfähigen Materialien vorgesehen sind.

14. Anordnung nach zumindest einem der vorhergehenden Ansprüche, **dadurch gekennzeichnet, daß** der Resonator (1) ein Dickenscher- oder Dickendehnschwinger ist.

15. Anordnung nach einem der vorhergehenden Ansprüche, **dadurch gekennzeichnet, daß** der Resonator (1) mit zumindest einer Beschichtung, insbesonders einer die Abscheidung von Partikeln auf der Resonatoroberfläche erlaubenden bzw. verbessernden Beschichtung, versehen ist.

## Claims

1. A piezoelectric resonator arrangement comprising a mount having at least two mounting elements and having at least one platelike piezoelectric resonator having at least one excitation electrode from which at least one electrically conductive strip extends preferably in the direction of the edge of the resonator, the resonator being clamped between the mounting elements, of which at least one element presses on the resonator with a force, said mounting elements abutting immediately and directly on at least one or the lateral surface of the resonator, **characterized in that** the resonator (1) is fixed between the mounting elements (6, 7, 11) without the use of an adhesive, that the_electrically conductive strip extends at least up to the lateral surface of the resonator, and that at least one adhesive-free electrical point of contact with the resonator (1) is provided on one or the lateral surface of the resonator, the electrical contacting forces for providing the electrical contact with said electrical point of contact lying essentially in one plane with the resonator (1).

2. An arrangement according to claim 1, **characterized in that** the electrical contacting forces exerted by the mounting elements (6, 7, 11) are directed essentially radially to a center of the resonator (1).

3. An arrangement according to claim 1 or 2, **characterized in that** on at least one of the mounting elements (6, 7, 11) at least one electrical contact surface is provided and faces at least one lateral surface of the resonator (1).

4. An arrangement according to claim 3, **characterized in that** on at least two mounting elements (6, 7, 11) at least one electrical contact surface is respectively provided which faces at least one lateral surface of the resonator (1), **in that** at least one second electrically conductive strip extends preferably_radially from at least one excitation electrode (2) of the resonator, and **in that** both conductive strips (2a) extend to the lateral surface of the resonator (1) and into the region, respectively, of one of the electrical contact surfaces of the mounting elements (6, 7, 11).

5. An arrangement according to claim 4, **characterized in that** the electrical contact surfaces of two mounting elements (6, 7, 11) are connected with one another via at least one arrangement for measuring the electrical resistance.

6. An arrangement according to claim 4, **characterized in that** the electrical contact surfaces of two mounting elements (6, 7, 11) are connected with one another via at least one arrangement for the production and regulation of an electrical current flow.

7. An arrangement according to any one of claims 1 to 6, **characterized in that** at least one of the mounting elements (6, 7, 11) is supported in elastically resilient manner or connected with a base structure (10) in an elastically resilient manner.

8. An arrangement according to any one of claims 1 to 7, **characterized in that** at least one of the mounting elements (6, 7, 11) is made up of an essentially rigid part (6, 6a, 7, 7a, 11) and a part (6b, 7b, 11a, 8) that is essentially elastically deformable, whereby the elastic part is located closer to a base structure (10).

9. An arrangement according to claim 8, **characterized in that** at least one of the mounting elements (6, 7, 11) is constructed as an oblong mounting arm having at least one essentially rigid longitudinal segment (6a, 7a, 11) and one essentially elastically deformable segment (6b, 7b, 11 a).

10. An arrangement according to claim 8 or 9, **characterized in that** at least one essentially rigid mounting element (6, 7, 11) is supported in a resilient manner by means of an elastic element (8).

11. An arrangement according to at least one of the preceding claims, **characterized in that** the mounting elements (6, 7, 11) are provided with mounting structures that determine a definite orientation of the installed resonator (1), and on which mounting structures the electrical contact surfaces are provided.

12. An arrangement according to at least one of the preceding claims, **characterized in that** at least the mounting elements (6, 7, 11) and preferably also the base structure (10), respectively, is manufactured from ceramic material, preferably as a one-piece construction.

13. An arrangement according to at least one of the preceding claims, **characterized in that** electrical lines and contact surfaces on the mounting arrangement are provided that are made of direct coatings with electrically conductive materials.

14. An arrangement according to at least one of the preceding claims, **characterized in that** the resonator (1) is a thickness shear oscillator or a thickness expansion oscillator.

15. An arrangement according to at least one of the preceding claims, **characterized in that** the resonator (1) is provided with at least one coating, in particular a coating to allow or ameliorate, respectively, the deposition of particles on the surface of the resonator.

## Revendications

1. Système de résonateur piézoélectrique, comprenant un support avec au moins deux éléments de support et au moins un résonateur piézoélectrique en forme de plaquette, avec au moins une électrode d'excitation, à partir de laquelle s'étend au moins une bande électriquement conductrice, de préférence radialement en direction du bord du résonateur, le résonateur étant serré entre les éléments de support, parmi lesquels au moins est soumis à une force vers le résonateur et qui s'appliquent immédiatement et directement sur la ou l'une des surfaces extérieures du résonateur, **caractérisé en ce que** le résonateur (1) est fixé sans collage entre les éléments de support (6, 7, 11), la bande électriquement conductrice s'étend au moins jusqu'à la surface extérieure du résonateur, et au moins un point de contact électrique sans collage avec le résonateur (1) est prévu sur la ou sur l'une des surfaces extérieures du résonateur (1), les forces de mise en contact électrique pour la réalisation du contact électrique audit point de contact se trouvant essentiellement sur un même plan avec le résonateur (1).

2. Système selon la revendication 1, **caractérisé en ce que** les forces de mise en contact électrique exercées par les éléments de support (6, 7, 11) sont dirigées essentiellement radialement par rapport au centre du résonateur (1).

3. Système selon la revendication 1, **caractérisé en ce qu'**au moins une surface de contact électrique est prévue sur au moins un des éléments de support (6, 7, 11) et tournée vers au moins une des surfaces extérieures du résonateur (1).

4. Système selon la revendication 3, **caractérisé en ce qu'**au moins une surface de contact électrique est prévue sur au moins deux éléments de support (6, 7, 11) et tournée vers au moins l'une des surfaces extérieures du résonateur (1), **en ce qu'**au moins une deuxième bande électriquement conductrice part d'au moins une électrode d'excitation (2) du résonateur (1), de préférence radialement, et les deux bandes conductrices (2a) s'étendent jusqu'à la surface extérieure du résonateur (1) et dans la région de l'une des surfaces de contact électrique de chacun des éléments de support (6, 7, 11).

5. Système selon la revendication 4, **caractérisé en ce que** les surface de contact électrique de deux éléments de support (6, 7, 11) sont reliées entre elles par au moins un dispositif de mesure de résistance électrique.

6. Système selon la revendication 4, **caractérisé en ce que** les surfaces de contact électrique de deux éléments de support (6, 7, 11) sont reliées entre elles par au moins un dispositif destiné à la réalisation et au réglage d'un courant électrique.

7. Système selon l'une des revendications 1 à 6, **caractérisé en ce qu'**au moins l'un des éléments de support (6, 7, 11) est monté élastiquement ou relié élastiquement à la structure de base (10).

8. Système selon l'une des revendications 1 à 7, **caractérisé en ce que** les éléments de support (6, 7, 11) sont constitués d'une pièce essentiellement immobile (6, 6a, 7, 7a, 11) et d'une pièce essentiellement déformable par élasticité (6b, 7b, 11a, 8), la pièce élastique se trouvant plus près de la structure de base (10).

9. Système selon la revendication 8, **caractérisé en ce qu'**au moins l'un des éléments de support est conçu comme un bras de support allongé (6, 7, 11), avec au moins une section longitudinale essentiellement immobile (6a, 7a, 11) et une section essentiellement déformable par élasticité (6b, 7b, 11a).

10. Système selon l'une des revendications 8 ou 9, **caractérisé en ce qu'**au moins un élément de support (6, 7, 11) essentiellement immobile est monté élastiquement, avec un élément élastique (8).

11. Système selon l'une des revendications précédentes, **caractérisé en ce que** les éléments de support (6, 7, 11) sont pourvus de structures de maintien prédéfinissant une certaine orientation du résonateur (1) installé et sur lesquelles sont prévues les surfaces de contact électrique.

12. Système selon l'une des revendications précédentes, **caractérisé en ce qu'**au moins les éléments de support (6, 7, 11), et de préférence également la structure de base (10), sont de préférence fabriqués d'une seule pièce en matériau céramique.

13. Système selon l'une des revendications précédentes, **caractérisé en ce que** des lignes électriques et des surfaces de contact électrique sur le dispositif de support sont prévues sous forme de revêtements directs réalisés à partir de matériaux électriquement conducteurs.

14. Système selon au moins l'une des revendications précédentes, **caractérisé en ce que** le résonateur (1) est un oscillateur de découpe de largeur ou un oscillateur d'expansion de largeur.

15. Système selon l'une des revendications précédentes, **caractérisé en ce que** le résonateur (1) est pourvu d'au moins un revêtement, en particulier d'un revêtement permettant ou améliorant le dépôt de particules à la surface du résonateur.
